# EUROPEAN PATENT APPLICATION

(11) **EP 4 811 662 A1**
(43) Date of publication of application: **23.09.2026**
(21) Application number: 26163248.3
(22) Date of filing: 09.03.2026
(51) Int. Cl.: H03K 17/22

(54) **RESET CIRCUIT AND CHIP**

(30) Priority: 19.03.2025 CN 202510331707
(71) Applicant: GigaDevice Semiconductor Inc., Haidian, Beijing (CN); GigaDevice Semiconductor (XIAN) Inc., Xi'an (CN); GigaDevice Semiconductor (Hefei) Inc., Hefei, Anhui (CN); Silead Inc., Shanghai 201210 (CN); GigaDevice Semiconductor (Shanghai) Inc., Shanghai 201210 (CN); Suzhou Freethink Information Technology Co., Ltd., Suzhou (CN)
(72) Inventor: HOU, Dequan, Beijing (CN); ZENG, Xinji, Beijing (CN)
(74) Representative: dompatent

(57) **Abstract**

The present invention provides a reset circuit and chip, in which a single voltage divider circuit can output both first and second tap voltages in response to a power supply voltage of the system. A POR function is provided during power-on of the system by comparing a first tap voltage with a first reference voltage using a first comparator. A BOR function is provided during operation of the system by comparing a second tap voltage with a second reference voltage using a second comparator. Thus, in the reset circuit of the present invention, the POR and BOR functions are provided based on shared use of the single voltage divider circuit, resulting in circuit area and cost savings.

## Description

### TECHNICAL FIELD

The present invention relates to the field of integrated circuits, and particularly to a reset circuit and chip.

### BACKGROUND

A chip typically incorporates a power-on reset (POR) circuit and a brown-out reset (BOR) circuit. During power-on of the chip, if a power supply voltage VCC is lower than a preset threshold V_{POR} for the POR circuit, the chip will undergo a reset. The chip starts to operate only when VCC reaches V_{POR}. Therefore, the POR circuit can ensure that various modules within the chip operate at an appropriate level of the power supply voltage VCC. A preset threshold V_{BOR} for the BOR circuit is usually higher than V_{POR}, and during operation of the chip, when VCC drops below V_{BOR}, some of the modules in the chip will be turned off. Thus, the BOR circuit enables a user to better control the chip's power consumption.

Conventionally, such BOR and POR circuits are designed as independent circuits. Due to large footprint of the two modules, reductions in the chip's area and cost are hard to achieve. Further, it is usually desirable for the chip to operate in a low power mode sometimes. However, the POR and BOR circuits, when enabled, still consume DC power, making reductions in the chip's power consumption also hard to achieve.

### SUMMARY

It is an object of the present invention to provide a reset circuit and chip, which enable shared use of a common voltage divider circuit by POR and BOR functions, resulting in circuit area and cost savings.

To this end, the present invention provides a reset circuit including:
a voltage divider circuit configured to detect a power supply voltage of a system and output a first tap voltage and a second tap voltage in response to the power supply voltage;
a first comparator coupled to the voltage divider circuit, the first comparator configured to compare the first tap voltage with a first reference voltage and thereby output a POR signal during a power-on process of the system; and
a second comparator coupled to the voltage divider circuit, the second comparator configured to compare the second tap voltage with a second reference voltage and thereby output a BOR signal during operation of the system,
wherein each of the POR and BOR signals is used to cause a reset of the system.

In the reset circuit of the present invention, the single voltage divider circuit can output both the first and second tap voltages in response to the power supply voltage of the system. The POR function is provided by comparing the first tap voltage with the first reference voltage using the first comparator during power-on of the system, and the BOR function is provided by comparing the second tap voltage with the second reference voltage using the second comparator during operation of the system. Thus, in the reset circuit of the present invention, the POR and BOR functions are provided through shared use of the single voltage divider circuit, resulting in circuit area and cost savings.

Optionally, the reset circuit may further include a first logic operation circuit, which is coupled to an output terminal of the first comparator and an output terminal of the second comparator and is configured to perform a logical operation on the POR and BOR signals and thereby output a system reset signal for causing the reset of the system. With this arrangement, the POR and BOR signals can each be used to cause a desired reset of the system.

Optionally, the voltage divider circuit may include a resistor string coupled between the power supply voltage and a ground of the system, wherein resistors in the resistor string are connected in series, and each of the first and second tap voltages is provided at an associated node in the resistor string. With this arrangement, the use of the structurally simple resistor string additionally simplifies the circuit and reduces its cost.

Optionally, the first tap voltage may be different from the second tap voltage, and the first reference voltage may be equal to the second reference voltage. Alternatively, the first and second tap voltages may be the same tap voltage, and the first reference voltage may be lower than the second reference voltage. With this arrangement, the circuit can be additionally simplified, and its cost can be reduced.

Optionally, the reset circuit may further include:
a decoder configured to decode brown-out-level control signals into n first enable signals; and
a selector circuit for selecting a range to be monitored, the selector circuit coupled to the decoder and the second comparator, the selector circuit configured to: when there is one second reference voltage for a single range and when the voltage divider circuit is able to provide second tap voltages for respective n different ranges, select a second tap voltage for a respective range from the second tap voltages for the respective n different ranges under the control of the n first enable signals and output it to the second comparator; or when there are second reference voltages for respective n different ranges and when the voltage divider circuit is able to provide one second tap voltage for a single range, select a second reference voltage for a respective range from the second reference voltages for the respective n different ranges under the control of the n first enable signals and output it to the second comparator.

With this arrangement, the reset circuit of the present invention is capable of low-power monitoring of the power supply voltage within different ranges, and the BOR signal output from the second comparator may be used to turn off associated circuit modules in the system. This multi-range power consumption control enables the system to operate at different levels of power consumption, which are suitable for various different use scenarios.

Optionally, the selector circuit may include n selector switches for the n respective first enable signals, each of the selector switches includes: a control terminal coupled to a respective one of the first enable signals; and an input terminal coupled to one of the second tap or reference voltages for a respective one of the ranges. With this arrangement, the circuit can be additionally simplified.

Optionally, the reset circuit may further include a first hysteresis control circuit including: a control terminal coupled to the output terminal of the first comparator; an input terminal coupled to the power supply voltage; and an output terminal coupled to the voltage divider circuit, the first hysteresis control circuit configured to be turned on after the system is successfully powered on and when the power supply voltage is higher than an associated first power loss threshold, thereby preventing an undesired inversion of the POR signal, the first power loss threshold being lower than a power-on threshold for the system.

With this arrangement, during or after power-on of the system, even when there are fluctuations in the power supply voltage, the POR signal output from the first comparator will not be inverted as long as the power supply voltage does not fluctuate below the first power loss threshold, preventing the system from experiencing an undesired POR. In other words, in addition to the POR function, the reset circuit of the present invention can provide a hysteresis function, which can enhance stability (or robustness) of the reset circuit against fluctuations in the power supply voltage.

Optionally, the first hysteresis control circuit may include a first switching transistor including: a gate serving as the control terminal of the first hysteresis control circuit and coupled directly, or via a first inverting circuit, to the output terminal of the first comparator; and a source and a drain, one of which is coupled to the power supply voltage and the other of which is coupled to the voltage divider circuit, the first switching transistor, when turned on, shorting a portion of the voltage divider circuit, thereby pulling up the first tap voltage. With this arrangement, the circuit can be additionally simplified, and its cost can be reduced.

Optionally, the reset circuit may further include a second hysteresis control circuit including: a control terminal coupled to the output terminal of the second comparator; an input terminal coupled to the power supply voltage; and an output terminal coupled to the voltage divider circuit, the second hysteresis control circuit configured to be turned on during operation of the system and when the power supply voltage is higher than a second power loss threshold, thereby preventing an undesired inversion of the BOR signal, the second power loss threshold being higher than a power-on threshold for the system and lower than a low-power threshold for the system.

With this arrangement, during operation of the system or in the event of loss of power, even when there are fluctuations in the power supply voltage, the BOR signal output from the second comparator will not be inverted as long as the power supply voltage does not fluctuate below the second power loss threshold, preventing the system from experiencing an undesired BOR. In other words, in addition to the BOR function, the reset circuit of the present invention can provide a hysteresis function, which can enhance stability (or robustness) of the reset circuit against fluctuations in the power supply voltage.

Optionally, the second hysteresis control circuit may include a second switching transistor including: a gate serving as the control terminal of the second hysteresis control circuit and coupled directly, or via a second inverting circuit, to the output terminal of the second comparator; and a source and a drain, one of which is coupled to the power supply voltage and the other of which is coupled to the voltage divider circuit, the first switching transistor, the second switching transistor, when turned on, shorting a portion of the voltage divider circuit, thereby pulling up the second tap voltage. With this arrangement, the circuit can be additionally simplified, and its cost can be reduced.

Optionally, the reset circuit may further include a decoder configured to decode brown-out-level control signals into n first enable signals,
wherein the second hysteresis control circuit includes n second switching transistors and n second logic operation circuits for second power loss thresholds for the respective n different ranges, where n is an integer greater than 1,
each of the second switching transistors including: a gate coupled to an output terminal of a respective one of the second logic operation circuits; and a source and a drain, one of which is coupled to the power supply voltage and the other of which is coupled to the voltage divider circuit, each of the second switching transistors, when turned on, shorting a respective portion of the voltage divider circuit, thereby pulling up the second tap voltage,
each of the second logic operation circuits including: a first input terminal coupled to a respective one of the first enable signals; and a second input terminal coupled to the output terminal of the second comparator, each of the second logic operation circuits configured to perform a logical AND or NAND operation on the respective first enable signal and the BOR signal.

With this arrangement, during operation of the system or in the event of loss of power, low power monitoring of fluctuations in the power supply voltage can be performed in different ranges to ensure that, for any range of interest being monitored, the BOR signal output from the second comparator will not be inverted as long as the power supply voltage does not fluctuate below a second power loss threshold associated with the range, preventing the system from experiencing an undesired BOR. In other words, in addition to providing BOR functions for various use scenarios with different power consumption requirements, the reset circuit of the present invention can provide associated hysteresis functions, which can enhance stability (or robustness) against fluctuations in the power supply voltage in such use scenarios.

Optionally, the different ranges may be associated with respective circuit modules in the system, wherein when successfully powered on, the system turns, based on the BOR signal output for one of the ranges, off a respective one of the associated circuit modules. With this arrangement, after successful power-on of the system, the reset circuit of the present invention enables low power monitoring of the power supply voltage in different ranges and can utilize a correspondingly generated BOR or system reset signal to turn off an associated circuit module in the system. This multi-range power consumption control enables the system to be suitably used in various use scenarios with different power consumption requirements.

Optionally, the first comparator may be activated by the power supply voltage whenever the latter is able to provide power, wherein the second comparator is coupled to a second enable signal and configured to be activated when enabled by the second enable signal.

With this arrangement, the reset circuit of the present invention is able to provide the POR function in any mode of operation of the chip and to selectively provide the BOR function if so required according to a user's configuration made in accordance with the practical use scenario.

Optionally, the second enable signal and/or the brown-out-level control signals may be user-configured, stored in a special non-volatile memory region of the system, and read from the special memory region upon a POR of the system. With this arrangement, a BOR of the system can be caused in a timely way in the event of low power.

On the basis of the same inventive concept, the present invention also provides a chip including the reset circuit of the present invention as defined above. Since the chip of the present invention incorporates the inventive reset circuit, its area and cost can be reduced.

### BRIEF DESCRIPTION OF THE DRAWINGS

Those of ordinary skill in the art will understand that the following drawings are presented to enable a better understanding of the present invention and not intended to limit the scope thereof in any sense, in which:
Fig. 1A is a schematic diagram showing an architecture of a reset circuit according to a first embodiment of the present invention;
Fig. 1B is a schematic diagram showing an exemplary structure of the reset circuit of Fig. 1A;
Fig. 2 is a schematic diagram showing the architecture of a reset circuit according to a second embodiment of the present invention;
Fig. 3A is a schematic diagram showing the architecture of a reset circuit according to a second embodiment of the present invention;
Fig. 3B is a schematic diagram showing an exemplary structure of the reset circuit of Fig. 3A;
Fig. 4A is a schematic diagram showing an exemplary architecture of a reset circuit according to a fourth embodiment of the present invention;
Figs. 4B and 4C are schematic diagrams showing two exemplary structures of the reset circuit of Fig. 4A;
Figs. 4D and 4E are schematic diagrams showing two different exemplary architectures of the reset circuit according to the fourth embodiment of the present invention;
Fig. 5A is a schematic diagram showing an architecture of a reset circuit according to a fifth embodiment of the present invention;
Fig. 5B is a schematic diagram showing an exemplary structure of the reset circuit of Fig. 5A;
Fig. 5C schematically illustrates a power supply voltage profile of the reset circuit of Fig. 5A over time;
Fig. 6 is a schematic diagram showing an architecture of a reset circuit according to a sixth embodiment of the present invention; and
Fig. 7 is a schematic diagram showing an architecture of a reset circuit according to a seventh embodiment of the present invention

### DETAILED DESCRIPTION

The following description sets forth numerous specific details in order to provide a more thorough understanding of the present invention. However, it will be apparent to those skilled in the art that the present invention can be practiced without one or more of these specific details. In other instances, well-known technical features have not been described in order to avoid unnecessary obscuring of the invention. It is to be understood that the invention may be embodied in many different forms and should not be construed as being limited to the embodiments set forth herein. Rather, these embodiments are provided so that this disclosure is thorough and conveys the scope of the invention to those skilled in the art. In the drawings, like reference numerals refer to like elements throughout. It will be understood that when an element is referred to as being "connected to" or "coupled to" another element, it can be directly connected or coupled to the other element, or intervening elements may also be present. In contrast, when an element is referred to as being "directly connected to" another element, there are no intervening elements. As used herein, the singular forms "a", "an" and "the" are intended to include the plural forms as well, unless the context clearly indicates otherwise. It will be further understood that the term "comprising" specifies the presence of stated features, steps, operations, elements, and/or components, but do not preclude the presence or addition of one or more other features, steps, operations, elements, components, and/or groups thereof. As used herein, the term "and/or" includes any and all combinations of the associated listed items.

### EXAMPLE 1

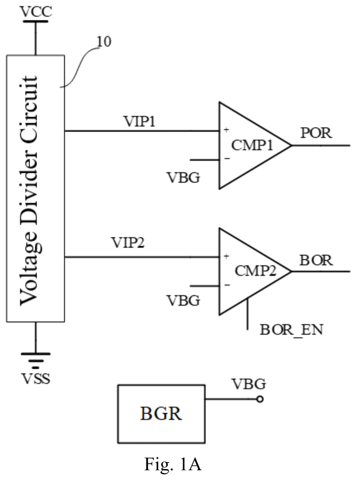

Referring to Fig. 1A, a reset circuit according to a first embodiment of the present invention includes a voltage divider circuit 10, a first comparator CMP1 and a second comparator CMP2.

The voltage divider circuit 10 is coupled to between a power supply voltage VCC of a system and a ground VSS, and is configured to detect the power supply voltage VCC of the system and output both a first tap voltage VIP1 and a second tap voltage VIP2 in response to the power supply voltage VCC. The system may be a circuit system of a chip.

A first input terminal (e.g., a non-inverting input terminal "+") of the first comparator CMP1 is coupled to the first tap voltage VIP1 from the voltage divider circuit 10, and a second input terminal (e.g., an inverting input terminal "-") thereof is coupled to a reference voltage VBG. The first comparator CMP1 is configured to compare the first tap voltage VIP1 with the reference voltage VBG during power-on of the system and output, based on the comparison, a power-on reset (POR) signal POR for causing a POR of the system.

A first input terminal (e.g., a non-inverting input terminal "+") of the second comparator CMP2 is coupled to the second tap voltage VIP2 from the voltage divider circuit 10, and a second input terminal (e.g., an inverting input terminal "-") thereof is coupled to the reference power source VBG. The second comparator CMP2 is configured to compare the second tap voltage VIP2 with the reference voltage VBG during operation of the system and output a brown-out reset (BOR) signal BOR for causing a BOR of the system.

In one example, the reference voltage VBG may be provided by an associated bandgap reference BGR in the system. VBG may be any suitable voltage, such as 1.2 V or 0.8 V. In an alternative example, the reference voltage VBG may be provided by an associated reference voltage generator circuit (not shown) in the system.

In one example, the first comparator CMP1 is activated by the power supply voltage VCC whenever the power supply voltage VCC is able to provide power. The second comparator CMP2 is coupled to a second enable signal BOR _EN and is configured to be activated when enabled by the second enable signal BOR _EN. With this arrangement, in the reset circuit of this embodiment, the POR function is active in all modes of operation of the system, while the BOR function is activated depending on a user's need. BOR _EN may be set either to 0 (to disable CMP2 and deactivate the BOR function), or to 1 (to enable CMP2 and activate the BOR function) by a user. In order to avoid this value of the second enable signal BOR _EN from being lost upon loss of power, it may be stored in a special non-volatile memory region (e.g., in option bytes in flash memory) of the system. Following a POR of the system, the value of the second enable signal BOR _EN may be read from the special memory region, and the second enable signal BOR _EN may be asserted to enable a timely BOR of the system in the event of low power of the system.

It will be understood that each of the voltage divider circuit 10, the first comparator CMP1 and the second comparator CMP2 may be of any suitable circuit design.

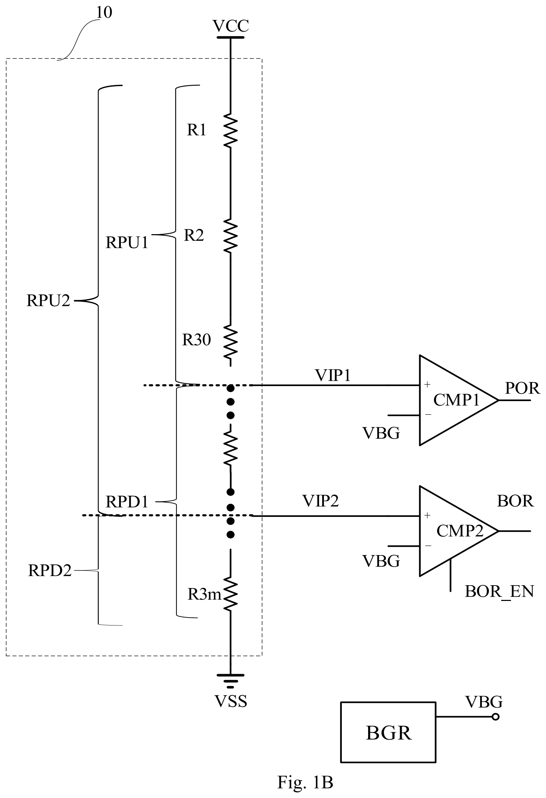

In one example, referring to Fig. 1B, the voltage divider circuit 10 includes resistors R1, R2 and R30 to R3m, which are connected in series into a resistor string. One terminal of the resistor R1 is coupled, as a leading terminal of the resistor string, to the power supply voltage VCC, and one terminal of the resistor R3m is coupled, as a trailing terminal of the resistor string, to the ground VSS of the system. Both the first tap voltage VIP1 and the second tap voltage VIP2 are voltages present at taps of the resistor string, which are nodes in the resistor string, where corresponding resistors are connected in series.

Denoting a resistance between the power supply voltage VCC and the first tap voltage VIP1 as RPU1, and a resistance between VIP1 and VSS as RPD1, the first tap voltage VIP1 satisfies: $VIP 1 = VCC ∗ \frac{RPD 1}{RPU 1 + RPD 1} .$

Likewise, denoting a resistance between the power supply voltage VCC and the second tap voltage VIP2 as RPU2, and a resistance between VIP2 and VSS as RPD2, the second tap voltage VIP2 satisfies: $VIP 2 = VCC ∗ \frac{RPD 2}{RPU 2 + RPD 2} .$

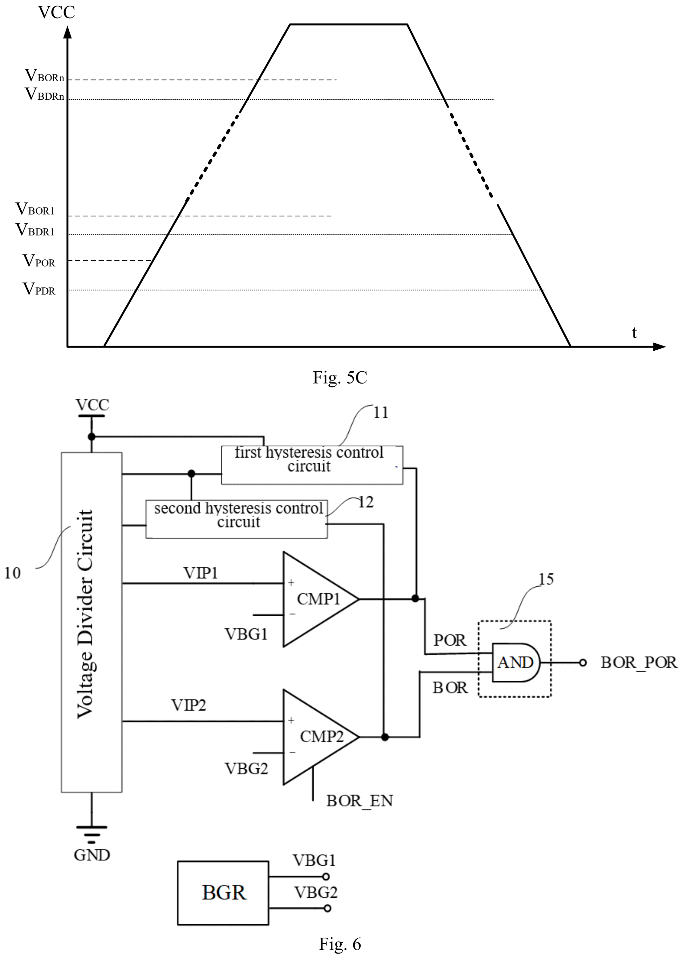

Operation of the reset circuit of this embodiment is described below with reference to Fig. 5C, in the context of the reset circuit shown in the schematic structural view of Fig. 1B.

First of all, the system is energized, and VCC ramps up from 0. If the user-configured second enable signal BOR _EN=0, CMP2 is disabled. Before VCC reaches the POR threshold V_{POR}, VIP1<VBG, and CMP1 outputs POR signal POR=0, indicating that the system is still in the POR sequence and not powered on yet.

When VCC rises to (i.e., becomes equal to) the POR threshold V_{POR} at a later time, the following is satisfied: $VIP 1 = {V}_{POR} ∗ \frac{RPD 1}{RPU 1 + RPD 1} = VBG .$

Accordingly, the POR signal POR from CMP1 is inverted, i.e., POR=1, indicating that the system has finished the POR sequence and been successfully powered on, and various circuit modules in the system start operation. After that, VCC further rises above V_{POR}, i.e., VCC>V_{POR}. Accordingly, VIP1>VBG and POR=1.

In the power-on sequence of the system, if the user-configured second enable signal BOR _EN=1, CMP2 operates, and before VCC reaches the BOR threshold V_{BOR} (V_{BOR} >V_{POR}), VIP2<VBG and CMP2 outputs the BOR signal BOR=0, maintaining some circuit modules in the system out of operation. If VCC further rises to VCC=V_{BOR} >V_{POR}, VIP2=VBG and BOR is inverted to BOR=1. At this point, since POR=1, said circuit modules in the system initiate operation. That is, these circuit modules remain out of operation (even when the system has been successfully powered on) until VCC≥V_{BOR}.

Similarly, during operation of the system, if needed, the user may set the second enable signal BOR _EN to 1, causing CMP2 to operate. In the event of loss of power, if VCC remains above the BOR threshold V_{BOR} (V_{BOR} >V_{POR}) at the beginning, then VIP2>VBG and BOR=1, allowing the system (or the chip) to operate normally. When VCC drops to V_{BOR}, i.e., VCC=V_{BOR}, the following is satisfied: $VIP 2 = VBOR ∗ \frac{RPD 2}{RPU 2 + RPD 2} = VBG .$

Accordingly, the BOR signal BOR from CMP2 is inverted, i.e., BOR=0, initiating a BOR of the system. Consequently, some circuit modules (not shown) in the system are turned off. In this way, the user can better control power consumption of the system.

Notably, in the example shown in Figs. 1A and 1B, VIP1 is input to the non-inverting input terminal "+" of CMP1, and VIP2 to the non-inverting input terminal "+" of CMP2, and both CMP1 and CMP2 operate based on the reference voltage VBG. However, this embodiment is not limited to this.

In another example of this embodiment, if required, VIP1 may be input to the inverting input terminal "-" of CMP1, and the reference voltage VBG to the non-inverting input terminal "+" of CMP1, allowing an inverted version of the POR signal to be output.

In yet another example of this embodiment, VIP2 may be input to the inverting input terminal "-" of CMP2, and the reference voltage VBG to the non-inverting input terminal "+" of CMP1, allowing an inverted version of the BOR signal to be output.

In still yet another example of this embodiment, if required, an inverting circuit (not shown, e.g., a NOT gate, an inverter or the like) may be coupled to at least one of an output terminal of CMP1 and an output terminal of CMP2, allowing inverted version(s) of the POR signal and/or the BOR signal to be output.

As can be seen from the above, in the reset circuit of this embodiment, the single voltage divider circuit can output both the first and second tap voltages in response to the power supply voltage of the system. The POR function is provided by comparing the first tap voltage with a first reference voltage using the first comparator during power-on of the system, and the BOR function is provided by comparing the second tap voltage with a second reference voltage using the second comparator during operation of the system. Thus, in the reset circuit of the present invention, the POR and BOR functions are provided through shared use of the single voltage divider circuit, resulting in circuit area and cost savings.

In addition, the reset circuit of this embodiment can output two independent reset signals, i.e., POR and BOR, which are configured to control respective subsets of circuit modules in the system. In this way, the chip can be successfully powered on simply when POR=1 by initiating operation of the subset of circuit modules under the control of the POR signal, with the subset of circuit modules under the control of the BOR signal remaining out of operation. The latter subset starts to operate when BOR=1 (and hence POR=1).

### EXAMPLE 2

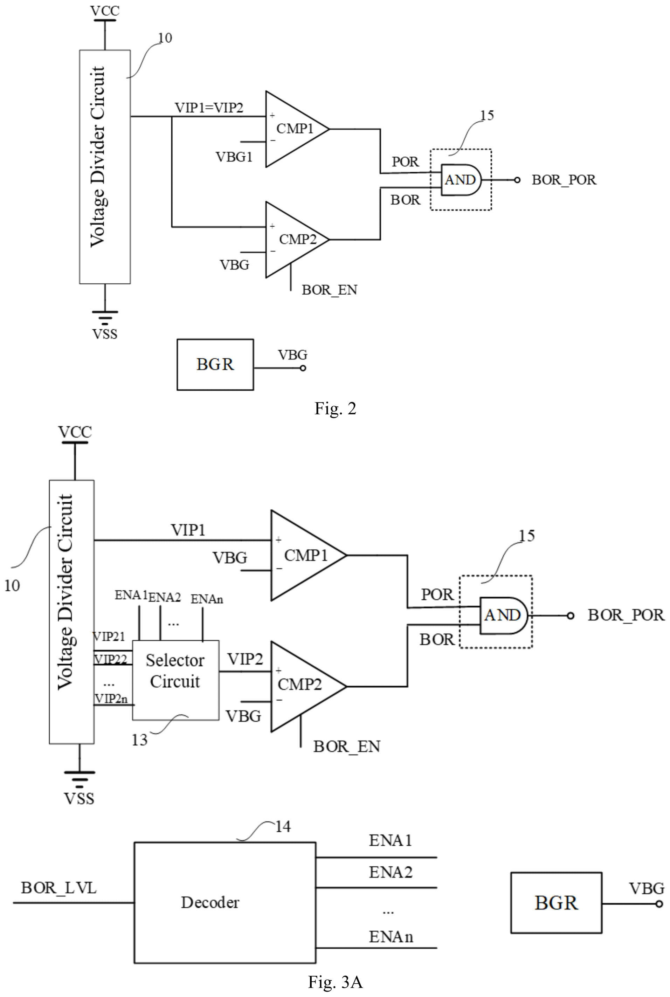

Referring to Fig. 2, a reset circuit according to a second embodiment of the present invention also includes a voltage divider circuit 10, a first comparator CMP1 and a second comparator CMP2. This embodiment differs from the first embodiment in that the reset circuit further includes a first logic operation circuit 15, which has: a first input terminal coupled to an output terminal of the first comparator CMP1; and a second input terminal coupled to an output terminal of the second comparator CMP2. The first logic operation circuit 15 is configured to perform a logical operation on a POR signal POR and a BOR signal BOR and thereby output a system reset signal BOR _ POR satisfying a reset need of the system for a particular use scenario.

The first logic operation circuit 15 may be of a circuit design capable of performing any suitable logical operation, such as AND, NAND, OR or NOR.

In one example, the first logic operation circuit 15 may include an AND gate AND, which can perform a logical AND operation on POR from CMP1 and BOR from CMP2 to produce BOR _ POR as desired.

In another example, the first logic operation circuit 15 may include a NAND gate, which can perform a logical NAND operation on POR from CMP1 and BOR from CMP2 to produce BOR _ POR as desired.

Further, in this embodiment, the voltage divider circuit 10 may be of the same design as in the first embodiment and, therefore, need not be described in further detail herein. CMP1 and CMP2 are coupled to the same reference voltage VBG.

Compared with the first embodiment, the reset circuit of this embodiment eventually outputs only the single reset signal BOR _POR. From the point of view of a user, there is no circuit module under the sole control of the reset signal BOR, and power-on can succeed only when the output reset signals BOR and POR are both "1".

### EXAMPLE 3

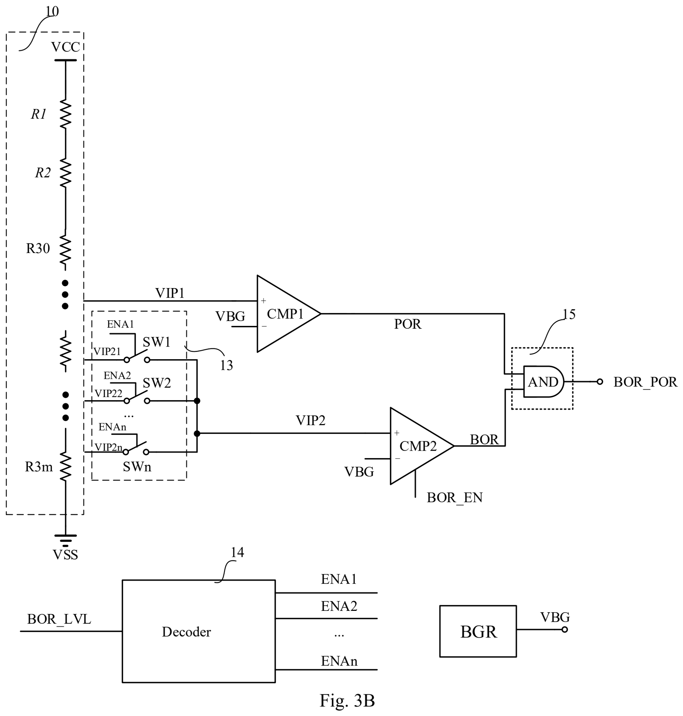

Referring to Figs. 3A to Fig. 3B, a reset circuit according to a third embodiment of the present invention also includes a voltage divider circuit 10, a first comparator CMP1 and a second comparator CMP2. This embodiment differs from the second embodiment (1) in that the voltage divider circuit 10 provides n second tap voltages VIP21 to VIP2n for respective different ranges, where n is an integer greater than 1 and (2) in that the reset circuit further includes: a selector circuit 13 for selecting a range to be monitored; and a decoder 14. The decoder 14 is configured to decode brown-out-level control signals BOR _LVL into n first enable signals ENA1 to ENAn. The selector circuit 13 is coupled to the decoder 14 and the second tap voltages VIP21 to VIP2n from the voltage divider circuit 10, and is configured to select a second tap voltage VIP2i for a desired i-th range from the n second tap voltages VIP21 to VIP2n for the respective ranges under the control of the n first enable signals ENA1 to ENAn and output it, as a desired second tap voltage VIP2, to the second comparator CMP2.

A value of the brown-out-level control signal BOR _LVL may be set by a user, and in order to avoid this value from being lost upon loss of power, it may be stored in a special non-volatile memory region (e.g., in option bytes in flash memory) of the system. Following a POR of the system, the value of brown-out-level control signal BOR _LVL may be read from the special memory region, and the brown-out-level control signal BOR _LVL may be asserted to enable a timely BOR of the system in the event of low power of the system.

The voltage divider circuit 10 may be of the same circuit design as in the first embodiment, and each of the selector circuit 13 and the decoder 14 may be of any suitable circuit design.

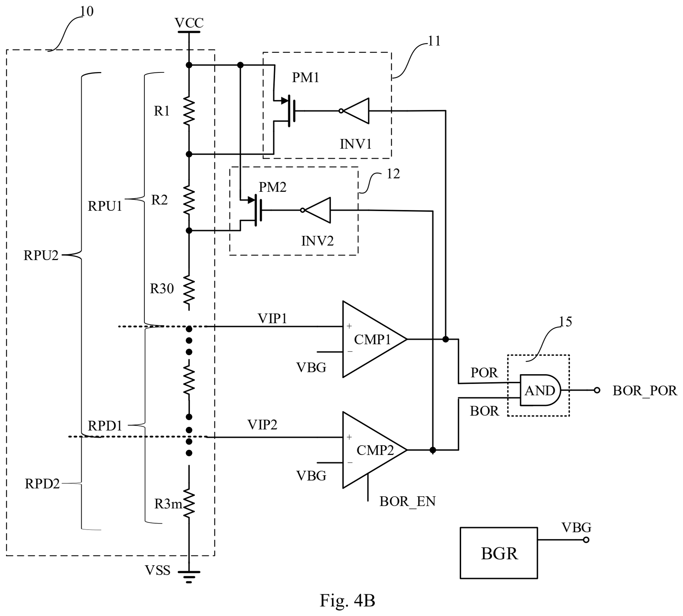

In one example, referring to Fig. 4B, the selector circuit 13 includes n selector switches SW1 to SWn, output terminals of the selector switches SW1 to SWn are connected together and to a first input terminal of CMP2. Input terminals of the respective selector switches SW1 to SWn are coupled to the respective second tap voltages VIP21 to VIP2n, and their respective control terminals are coupled to the respective first enable signals ENA1 to ENAn. For example, the control terminal of the selector switch SW1 is coupled to the first enable signal ENA1, and the input terminal of the selector switch SW1 is coupled to the second tap voltage VIP21; the control terminal of the selector switch SW2 is coupled to the first enable signal ENA2, and the input terminal of the selector switch SW2 is coupled to the second tap voltage VIP22; ...; and the control terminal of the selector switch SWn is coupled to the first enable signal ENAn, and the input terminal of the selector switch SWn is coupled to the second tap voltage VIP2n.

In this embodiment, the reset circuit can provide a POR function in the same way as in the first embodiment, and further description thereof is therefore omitted for the sake of brevity.

With combined reference to Figs. 4B and 5C, assume that the user has set low-power thresholds V_{BOR1} to V_{BORn} for the n ranges and that it is desired to perform BOR monitoring based on a low-power threshold V_{BORi} for an i-th range in accordance with the actual circumstances. The reset circuit of this embodiment may provide a BOR function in a manner as described below.

First of all, the decoder 14 decodes the user-configured brown-out-level control signal BOR _LVL into the first enable signals ENA1 to ENAn, in which a first enable signal ENAi turns on a selector switch SWi, first enable signals ENA1 to ENAi-1 turn off selector switches SW1 to SWi, and first enable signals ENAi+1 to ENAn turn off selector switches SWi+1 to SWn, in the selector circuit 13. Accordingly, a second tap voltage VIP2i from the voltage divider circuit 10 is provided to CMP2 as a desired second tap voltage VIP2.

During a rise of VCC, before it reaches V_{BORi}, i.e., when VCC<V_{BORi}, VIP2i<VBG and CMP2 outputs BOR=0, maintaining some circuit modules in the system in a BOR state (or a deactivated or OFF state). When VCC≥V_{BORi}, VIP2i≥VBG and CMP2 outputs BOR=1, driving those circuit modules in the system out of the BOR state into operation.

During a drop of VCC, when VCC≥V_{BORi}, VIP2i≥VBG and CMP2 outputs BOR=1, maintaining those circuit modules in the system in operation. When VCC<V_{BORi}, VIP2i<VBG and CMP2 outputs BOR=0, bringing those circuit modules in the system into the BOR state, where they are turned off to enable the system to consume less power.

Further, in this embodiment, each range V_{BORi} is associated with a respective subset of circuit modules in the system. After being successfully powered on, the system can turn off a desired subset of circuit modules using a BOR signal BOR or a system reset signal BOR _POR output in the respective associated range. In this way, power consumption of the system can be controlled at a level suitable for a particular use scenario.

As can be seen from the above, in the reset circuit of this embodiment, the voltage divider circuit can produce n second tap voltages in respective user-defined ranges (corresponding to respective low-power thresholds), enabling low-power monitoring in different ranges of the power supply voltage. Additionally, a BOR signal BOR output from the second comparator can be used to turn off an associated subset of circuit modules in the system. In this way, multi-range power consumption control of the system is achieved, which enables the system to operate in various power consumption modes suitable for different use scenarios.

### EXAMPLE 4

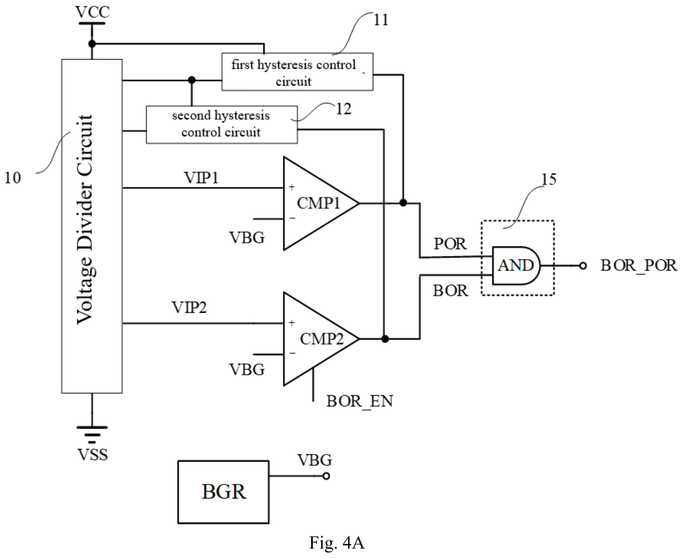

Referring to Figs. 4A to 4E, a reset circuit according to a fourth embodiment of the present invention also includes a voltage divider circuit 10, a first comparator CMP1 and a second comparator CMP2. This embodiment differs from the second embodiment in that the reset circuit further includes at least one of a first hysteresis control circuit 11 and a second hysteresis control circuit 12.

In one example, referring to Figs. 4A and 4B, the reset circuit includes both the first hysteresis control circuit 11 and the second hysteresis control circuit 12.

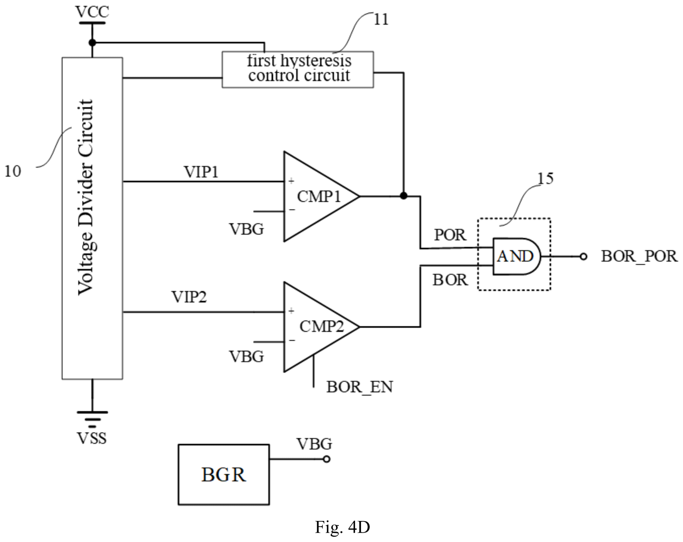

In another example, referring to Fig. 4D, the reset circuit includes the first hysteresis control circuit 11, but not the second hysteresis control circuit 12.

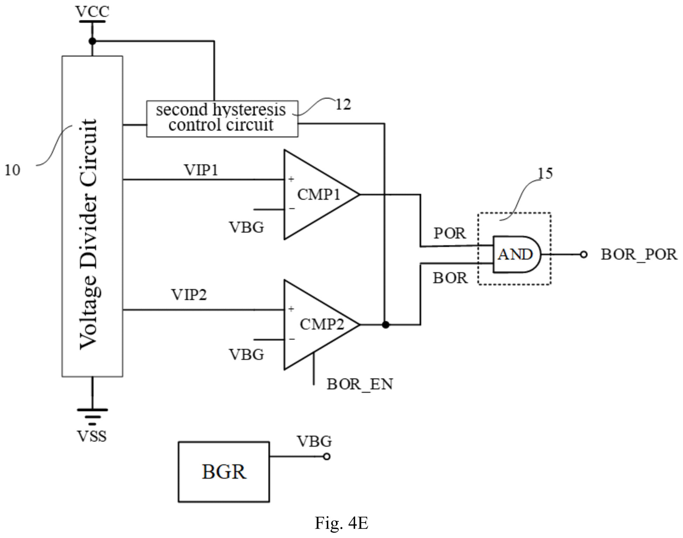

In yet another example, referring to Fig. 4E, the reset circuit includes the second hysteresis control circuit 12, but not the first hysteresis control circuit 11.

A control terminal of the first hysteresis control circuit 11 is coupled to an output terminal of the first comparator CMP1. An input terminal of the first hysteresis control circuit 11 is coupled to a power supply voltage VCC. An output terminal of the first hysteresis control circuit 11 is coupled to the voltage divider circuit 10. The first hysteresis control circuit 11 is configured to be turned on when the power supply voltage VCC rises above a first power loss threshold V_{PDR} of the system after it is successfully powered on to prevent an undesired inversion of an output POR signal POR from the first comparator CMP1 due to fluctuations in VCC. The first power loss threshold V_{PDR} is lower than a power-on threshold V_{POR} of the system.

A control terminal of the second hysteresis control circuit 12 is coupled to an output terminal of the second comparator CMP2. An input terminal of the second hysteresis control circuit 12 is coupled to the power supply voltage VCC, or to the output terminal of the first hysteresis control circuit 11. An output terminal of the second hysteresis control circuit 12 is coupled to the voltage divider circuit 10. The second hysteresis control circuit 12 is configured to be turned on when the power supply voltage VCC rises above a second power loss threshold V_{BDR} during operation of the system to prevent an undesired inversion of an output BOR signal BOR from the second comparator CMP2 due to fluctuations in VCC. The second power loss threshold V_{BDR} is higher than power-on threshold V_{POR} of the system and lower than its low-power threshold V_{BOR}.

It will be understood that the voltage divider circuit 10 may be of the same circuit design as in the first embodiment and each of the first hysteresis control circuit 11 and the second hysteresis control circuit 12 may be of any suitable circuit design, in this embodiment.

In one example, referring to Fig. 4B, the first hysteresis control circuit 11 includes a first switching transistor PM1, which may be implemented as a p-type switching transistor (e.g., a PMOS transistor, a p-type BJT transistor, a PNP transistor, etc.). This can additionally simplify the circuit and reduce its cost. A gate of the first switching transistor PM1 serves as the control terminal of the first hysteresis control circuit 11 and is coupled to an output terminal of a first inverting circuit INV1. An input terminal of the first inverting circuit INV1 is coupled to the output terminal of the first comparator CMP1. A source of the first switching transistor PM1 is coupled to the power supply voltage VCC, and a drain of the first switching transistor PM1 is coupled to a node between resistors R1 and R2 in the voltage divider circuit 10. When the first switching transistor PM1 is turned on, the resistor R1 is shorted, pulling up a first tap voltage VIP1. The first inverting circuit INV1 may be of any suitable circuit design, such as inverter or NOT gate.

The reset circuit incorporating the first hysteresis control circuit 11 performs a hysteresis function in a manner as described below.

During power-on, denoting a resistance between VCC and VIP1 as RPU1 and a resistance between VIP1 and VSS as RPD1, the following is satisfied: $VIP 1 = VCC ∗ \frac{RPD 1}{RPU 1 + RPD 1} .$

When VCC drops below a POR threshold V_{POR}, VIP1<VBG and CMP1 outputs POR=0, turning off PM1 and putting the system in a POR state.

When VCC rises above the POR threshold V_{POR}, VIP1>VBG and CMP1 outputs POR=1, starting operation of the system. As a result, PM1 is turned on, shorting R1 and updating VIP1 to VIP1_{B}, which varies as a function of VCC: $VIP {1}_{B} = VCC ∗ \frac{RPD 1}{RPU 1 - R 1 + RPD 1} .$

At a given level of VCC, VIP1_{B}>VIP1.

When VCC=V_{PDR}<V_{POR}, VIP1_{B}=VBG, i.e., $VIP {1}_{B} = {V}_{PDR} ∗ \frac{RPD 1}{RPU 1 - R 1 + RPD 1} = VBG .$

Thus, R1 is combined with PM1 to provide the hysteresis function, which sets a first power loss threshold V_{PDR} (<V_{POR}) for a POR function. After the system (or chip) is successfully powered on, if VCC fluctuates or is subject to a loss of power, POR=0 is output only when VCC drops below V_{PDR}, putting the system (or chip) into a POR state. In other words, after successful power-on of the system (or chip), the POR signal POR from CMP1 will not be inverted when VCC fluctuates between V_{PDR} and V_{POR}. Apparently, this hysteresis function enhances stability and robustness of a POR circuit consisting of the voltage divider circuit 10 and the first comparator CMP1 against fluctuations in the VCC voltage.

It will be understood that, in other examples, with additional reference to Fig. 4B, the first switching transistor PM1 may be replaced with an n-type switching transistor (e.g., an NMOS transistor, an N-type BJT transistor, an NPN transistor, etc.). In this case, the first inverting circuit INV1 may be omitted, and the gate of the first switching transistor PM1 may be instead directly coupled to the output terminal of CMP1.

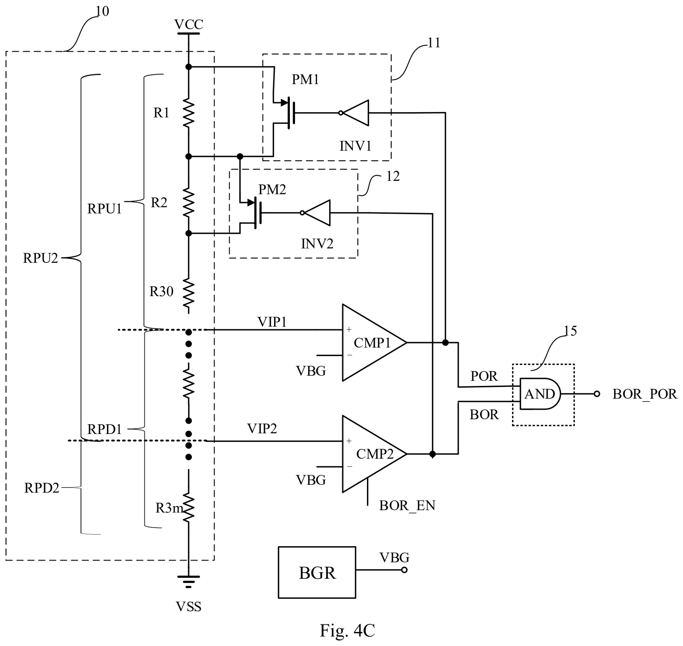

In one example, referring to Figs. 4B and 4C, the second hysteresis control circuit 12 includes a second switching transistor PM2, which is a p-type switching transistor (e.g., a PMOS transistor, a P-type BJT transistor, a PNP transistor, etc.). This can additionally simplify the circuit and reduce its cost. A gate of the second switching transistor PM2 serves as the control terminal of the second hysteresis control circuit 12 and is coupled to an output terminal of a second inverting circuit INV2. An input terminal of the second inverting circuit INV2 is coupled to the output terminal of the second comparator CMP2. A source of the second switching transistor PM2 is coupled to the power supply voltage VCC (see Fig. 4B), or to the drain of the first switching transistor PM1 (i.e., the output terminal of the first hysteresis control circuit 11). A drain of the second switching transistor PM2 is coupled to a node between resistors R2 and R30 in the voltage divider circuit 10. When the second switching transistor PM2 is turned on, the resistor R2 is shorted, pulling up a second tap voltage VIP2. The second inverting circuit INV2 may be of any suitable circuit design, such as inverter or NOT gate.

In this embodiment, the second comparator CMP2 and the voltage divider circuit 10 make up a BOR circuit, which starts to operate only when CMP1 outputs POR=1 (i.e., when VCC rises above V_{POR}).

The reset circuit incorporating the second hysteresis control circuit 12 shown in Figs. 4B and 4C performs a hysteresis function in a manner as described below.

A resistance between VCC and VIP2 is denoted as RPU2, and a resistance between VIP2 and VSS as RPD2. In the case of PM1 being included, when POR=1, PM1 is turned on, and RPU2+RPD2=RPU1+RPD1-R1. Accordingly, the following is satisfied: $VIP 2 = VCC ∗ \frac{RPD 2}{RPU 2 + RPD 2} .$

When VCC>V_{POR} and is lower than the low-power threshold V_{BOR}, VIP2<VBG and CMP2 outputs the BOR signal BOR=0, turning off PM2 and bringing the system into a BOR state. When VCC>V_{BOR}, VIP2>VBG and CMP2 outputs BOR=1, turning on PM2. Consequently, R2 is shorted, and VIP2 is updated to VIP2_{B}, which varies as a function of VCC: $VIP {2}_{B} = VCC ∗ \frac{RPD 2}{RPU 2 - R 2 + RPD 2} .$

At a given level of VCC, VIP2_{B}>VIP2.

When V_{POR} <VCC=VB_{DR}<VBOR, VIP2_{B}=VBG, i.e., $VIP {2}_{B} = {V}_{BDR} ∗ \frac{RPD 2}{RPU 2 - R 2 + RPD 2} = VBG .$

Thus, R2 is combined with PM2 to provide the hysteresis function, which sets a second power loss threshold V_{BDR} (which is higher than V_{POR} and lower than V_{BOR}) for a BOR function. After the system (or chip) is successfully powered on, if VCC fluctuates or is subject to a loss of power, BOR=0 is output only when VCC rises above V_{POR} but remains below V_{BDR}, putting the system (or chip) into a BOR state. In other words, after successful power-on of the system (or chip), the BOR signal BOR from CMP2 will not be inverted when VCC fluctuates between V_{BDR} and V_{BOR}. Apparently, this hysteresis function enhances stability and robustness of the BOR circuit consisting of the voltage divider circuit 10 and the second comparator CMP2 against fluctuations in the VCC voltage.

It will be understood that, in other examples, with combined reference to Figs. 4B and 4C, the second switching transistor PM2 may be replaced with an n-type switching transistor (e.g., an NMOS transistor, an n-type BJT transistor, an NPN transistor, etc.) In this case, the second inverting circuit INV2 may be omitted, and the gate of the second switching transistor PM2 may be instead directly coupled to the output terminal of CMP2.

### EXAMPLE 5

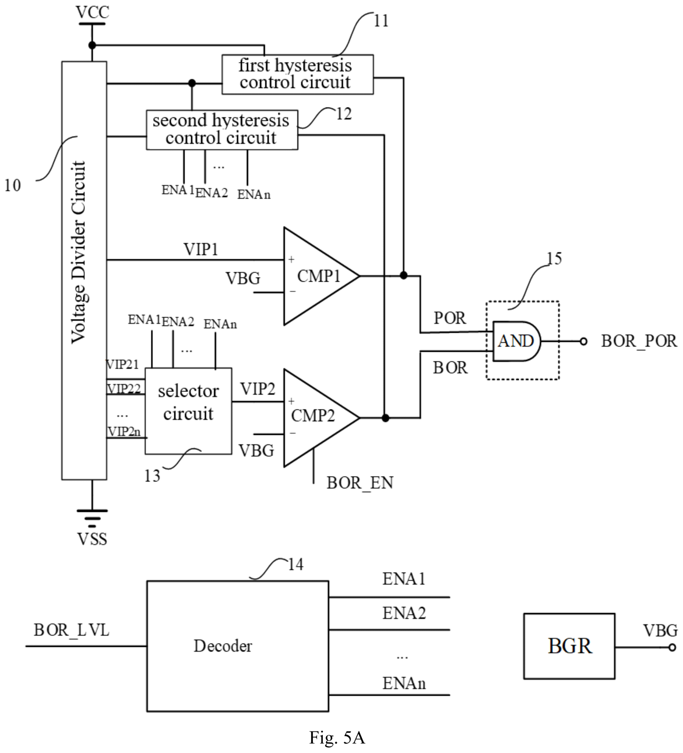

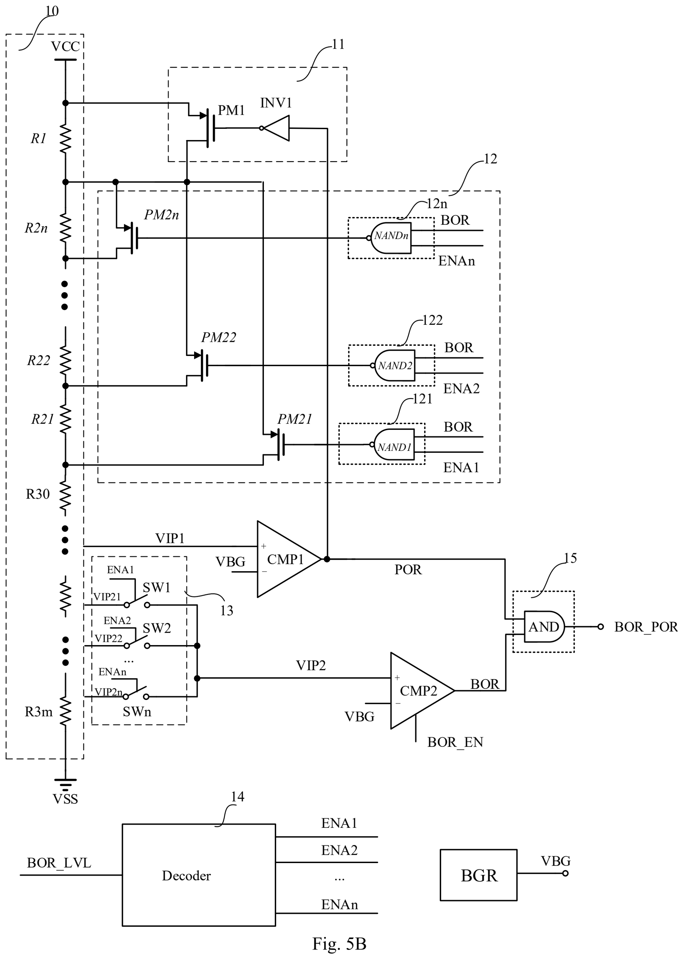

Referring to Figs. 5A and 5B, similar to the reset circuit of the second embodiment, a reset circuit according to a fifth embodiment of the present invention also includes a voltage divider circuit 10, a first comparator CMP1, a second comparator CMP2, a selector circuit 13 for selecting a range to be monitored and a decoder 14. The voltage divider circuit 10 provides n second tap voltages VIP21 to VIP2n in respective different ranges, where n is an integer greater than 1. The decoder 14 is configured to decode user-configured brown-out-level control signals BOR _LVL (optionally by determining their numerical values) associated with the respective ranges into respective n first enable signals ENA1 to ENAn. The selector circuit 13 is coupled to the decoder 14 and the second tap voltages VIP21 to VIP2n from the voltage divider circuit 10, and is configured to select a second tap voltage VIP2i for a desired i-th range from the n second tap voltages VIP21 to VIP2n for the respective ranges under the control of the n first enable signals ENA1 to ENAn and output it, as a desired second tap voltage VIP2, to the second comparator CMP2.

The voltage divider circuit 10, the selector circuit 13 and other components may be all of the same circuit designs as their counterparts in the third embodiment and, therefore, need not be described in further detail herein.

This embodiment differs from the third embodiment (1) in that the reset circuit further includes at least one of a first hysteresis control circuit 11 and a second hysteresis control circuit 12 and (2) in that, in the case of the second hysteresis control circuit 12 being included, the second hysteresis control circuit 12 is coupled to the decoder 14 and the voltage divider circuit 10 and turns on, under the control of the n first enable signals ENA1 to ENAn, a path for providing a hysteresis function for the desired range.

The first hysteresis control circuit 11 may be of the same circuit design as in the fourth embodiment and, therefore, need not be described in further detail herein.

With combined reference to Figs. 5B and 5C, in one example, the voltage divider circuit 10 includes a resistor string consisting of series-connected resistors R1, R2n to R21 and R30 to R3m. A first tap voltage VIP1 is provided at one node, and a second tap voltage VIP2 at another node, in a resistor string portion consisting of R21 to R3m. The first hysteresis control circuit 11 includes a first switching transistor PM1, and a drain of the first switching transistor PM1 is coupled to a node between R1 and R21. The second hysteresis control circuit 12 includes n second switching transistors PM21 to PM2n and n second logic operation circuits 121 to 12n, each type of circuits being associated with second power loss thresholds V_{BDR1} to V_{BDRn} for the respective n ranges, where n is an integer greater than 1.

The second logic operation circuit 121 includes a NAND gate NAND1. A first input terminal of the NAND gate NAND1 is coupled to ENA1, and a second input terminal of the NAND gate NAND1 is coupled to an output terminal of CMP2, thereby allowing the NAND gate NAND1 to perform a logical NAND operation on ENA1 and BOR. An output terminal of the NAND gate NAND1 is coupled to a gate of PM21, and a source of PM21 is coupled to VCC, or to a drain of PM1. A drain of PM21 is coupled to a node between the resistors R21 and R30. With this arrangement, when PM21 is turned on, R21 is shorted, pulling up the second tap voltage VIP21 for a first range. The second logic operation circuit 122 includes a NAND gate NAND2. A first input terminal of the NAND gate NAND2 is coupled to ENA2, and a second input terminal of the NAND gate NAND2 is coupled to the output terminal of CMP2, thereby allowing the NAND gate NAND2 to perform a logical NAND operation on ENA2 and BOR. An output terminal of the NAND gate NAND2 is coupled to a gate of PM22, and a source of PM22 is coupled to VCC, or to the drain of PM1. A drain of PM22 is coupled to a node between the resistors R21 and R22. With this arrangement, when PM22 is turned on, R22 is shorted, pulling up the second tap voltage VIP22 for a second range. Each of the remaining second logic operation circuit is wired and operates in a similar way. The second logic operation circuit 12i (1≤i≤n) includes a NAND gate NANDi. A first input terminal of the NAND gate NANDi is coupled to ENAi, and a second input terminal of the NAND gate NANDi is coupled to the output terminal of CMP2, thereby allowing the NAND gate NANDi to perform a logical NAND operation on ENAi and BOR. An output terminal of the NAND gate NANDi is coupled to a gate of PM2i, and a source of PM2i is coupled to VCC, or to the drain of PM1. A drain of PM2i is coupled to a node between the resistors R2(i-1) and R2i. With this arrangement, when PM2i is turned on, R2i is shorted, pulling up the second tap voltage VIP2i for the i-th range. The second logic operation circuit 12n includes a NAND gate NANDn. A first input terminal of the NAND gate NANDn is coupled to ENAn, and a second input terminal thereof is coupled to the output terminal of CMP2, thereby allowing the NAND gate NANDn to perform a logical NAND operation on ENAn and BOR. An output terminal of the NAND gate NANDn is coupled to a gate of PM2n, and a source of PM2n is coupled to VCC, or to the drain of PM1. A drain of PM2n is coupled to a node between the resistors R2(n-1) and R2n. With this arrangement, when PM2n is turned on, R2n is shorted, pulling up the second tap voltage VIP2n for the n-th range.

In other examples, at least one of NAND1 to NANDn may be replaced with NAND logic circuit(s) each consisting of an inverter and an AND gate.

It will be understood that since PM21 to PM2n discussed above are all p-type switching transistors (e.g., PMOS, PNP or other transistors), the second logic operation circuits 121 to 12n are all implemented as NAND gates (or circuits each consisting of an AND gate and an inverter). However, the present invention is not so limited, as in other embodiments of the present invention, any switching transistor PMi of PM21 to PM2n may be replaced with an n-type switching transistor (e.g., an NMOS, NPN or other transistor). In this case, the corresponding second logic operation circuit 12i may be implemented as any suitable logic AND circuit, such as an AND gate.

In this embodiment, the different ranges are associated with respective subsets of circuit modules in the system, and a user may write brown-out-level control signals BOR _LVL (optionally numeral values thereof) associated with the respective ranges, which may be determined in accordance with practical requirements, to a special non-volatile memory region (e.g., option bytes in flash memory) of the system. In this way, in a power-on sequence of the chip, when POR=1 (i.e., upon successful power-on), the chip may read the brown-out-level control signals BOR _LVL for the respective n ranges from the flash memory and produce first enable signals ENA1 to ENAn for the respective ranges. Each of the first enable signals ENA1 to ENAn may be used to turn on a respective one of the selector switches SW1 to SWn to allow a second tap voltage VIP2 for a desired one of the ranges to be selected and provided to CMP2 to enable low power monitoring within this desired range of VCC, and to turn off the respective subset of circuit modules in the system with the aid of a correspondingly generated BOR or system reset signal to also enable power consumption of the system over the desired range. In this way, low power monitoring and system power consumption control can be achieved within multiple ranges of the power supply voltage can be achieved to enable the system to be suitable used in various scenarios with different power consumption demands.

The reset circuit of this embodiment can provide a POR function in the same manner as in the first embodiment. In addition, it can also provide a hysteresis function in the same manner as in the fourth embodiment. Repeated description of these functions is deemed unnecessary and omitted herein.

With combined reference to Figs. 5B and 5C, assume the user has configured low-power thresholds V_{BOR1} to V_{BORn} and second power loss thresholds V_{BDR1} to V_{BDRn}, for respective n ranges. The voltage divider circuit 10 may provide n second tap voltages VIP21 to VIP2n for the respective ranges. Both V_{BOR1} to V_{BORn} and V_{BDR1} to V_{BDRn} are increasing sequences and satisfy: ${V}_{POR} < {V}_{BDR 1} < {V}_{BOR 1} < {V}_{BDR 2} < {V}_{BOR 2} < {V}_{BDR 3} < {V}_{BOR 3 … …} < {V}_{BDRn} < {V}_{BORn} .$

When it is decided in accordance with the actual circumstances to use the low-power threshold V_{BORi} for the i-th range for BOR monitoring, the reset circuit of this embodiment may perform a BOR function and a hysteresis function in a manner as described below:
At first, the user has configured brown-out-level control signals BOR _LVL for respective n ranges (optionally, but setting them to different values), and the decoder 14 reads and decodes the values of the brown-out-level control signals BOR _LVL for the n ranges, resulting in respective first enable signals ENA1 to ENAn. Accordingly, the selector switch SWi is turned on, with SW1 to SWi and SWi+1 to SWn all being maintained OFF, to provide the second tap voltage VIP2i to CMP2. Denoting a resistance between VCC and VIP2i as RPU2i and a resistance between VIP2 and VSS as RPD2i, if PM1 is included, then PM1 is turned on because of POR=1, and RPU2i+RPD2i=RPU1+RPD1-R1. Therefore, the following is satisfied: $VIP 2 i = VCC ∗ \frac{RPD 2 i}{RPU 2 i + RPD 2 i} .$

When VCC>V_{POR} and is lower than the low-power threshold V_{BORi}, VIP2i<VBG and CMP2 outputs a BOR signal BOR=0, turning off PM21 to PM2n and bringing the system into a BOR state. When VCC>V_{BORi}, VIP2i>VBG and CMP2 outputs BOR=1, turning on PM2i. Consequently, R2i is shorted, and VIP2i is updated to VIP2i_{B}, which varies as a function of VCC: $VIP 2 {i}_{B} = VCC ∗ \frac{RPD 2 i}{RPU 2 i - R 2 + RPD 2 i} .$

At a given level of VCC, VIP2i_{B}>VIP2i.

When VCC=V_{BDRi}<V_{BORi}, VIP2i_{B}=VBG, and BOR from CMP2 is inverted.

Thus, R2i is combined with PM2i to provide a hysteresis function for a BOR function for the i-th range. The hysteresis function sets a second power loss threshold V_{BDRi} (which is higher than V_{POR} and the second power loss threshold V_{BDRi-1} for the (i-1)-th range and lower than V_{BORi}) for the BOR function. After the system (or chip) is successfully powered on, if VCC fluctuates or is subject to a loss of power, BOR=0 is output only when VCC rises above V_{BDRi-} but remains below V_{BORi}, putting the system (or chip) into a BOR state. In other words, after successful power-on of the system (or chip), the BOR signal BOR from CMP2 will not be inverted when VCC fluctuates between V_{BDRi} and V_{BORi}.

Apparently, compared with the reset circuit of the third embodiment, the reset circuit of this embodiment can not only enable low power monitoring in various ranges of the power supply voltage, but also enhances stability and robustness of a BOR circuit consisting of the voltage divider circuit 10 and the second comparator CMP2 against fluctuations in the VCC voltage within those ranges. Additionally, the BOR signal BOR from the second comparator output can be used to turn off an associated subset of circuit modules in the system. In this way, multi-range power consumption control of the system is achieved, which enables the system to operate in various power consumption modes suitable for different use scenarios.

### EXAMPLE 6

Referring to Fig. 6, a reset circuit according to a sixth embodiment of the present invention also includes a voltage divider circuit 10, a first comparator CMP1, a second comparator CMP2 and a first logic operation circuit 15. This embodiment differs from the second embodiment (1) in that the voltage divider circuit 10 provides a single tap voltage in lieu of the first tap voltage VIP1 and the second tap voltage VIP2. The first comparator CMP1 is coupled to a first reference voltage VBG1, and the second comparator CMP2 is coupled to a second reference voltage VBG2. The first reference voltage VBG1 corresponds to a power-on threshold V_{POR} for the system, and the second reference voltage VBG2 corresponds to a low-power threshold V_{BOR} for the system. V_{POR}<V_{BOR}, and hence VBG1<VBG2. This embodiment differs also from the second embodiment (2) in further including at least one of a first hysteresis control circuit 11 and a second hysteresis control circuit 12 for providing a desired hysteresis function.

VBG1 and VBG2 may be provided by the same bandgap reference, or by an associated reference voltage generator circuit in the system. However, the present invention is not particular limited in any sense in this regard. The first hysteresis control circuit 11 may be of the same circuit design as in the fourth embodiment and, therefore, need not be described in further detail herein. The second hysteresis control circuit 12 may be of the same circuit design as in the fifth embodiment and, therefore, need not be described in further detail herein. The reset circuit of this embodiment can provide a POR function and optionally an associated hysteresis function, as well as a BOR function and optionally an associated hysteresis function, in the same manner as in the third embodiment. Repeated description of these functions is deemed unnecessary and omitted herein.

In this embodiment, the reset circuit can similarly provide the POR and BOR functions based on shared use of the single voltage divider circuit. Additionally, in the event of a POR and/or a BOR, hysteresis function(s) can be provided to ensure that a corresponding reset signal will not be inverted as long as the power supply voltage does not fluctuate below an associated threshold. This can prevent an undesired reset of the system, enhancing its stability (or robustness) against fluctuations in the power supply voltage during practical use.

Further, the reset circuit of this embodiment may be designed so that the tap voltage is closer to VSS than VIP1 or VIP2 to increase RPU1 or RPU2.

In one example, VBG1 and VBG2 are both derived from a 1.2 V bandgap reference, or obtained by dividing reference voltages. In this case, VBG1≤1.2 V and VBG2≤1.2 V. For example, in the case of V_{BOR}=2.9 V, RPD2/(RPD2+RPU2)≤1.2V/2.9V may be satisfied.

### EXAMPLE 7

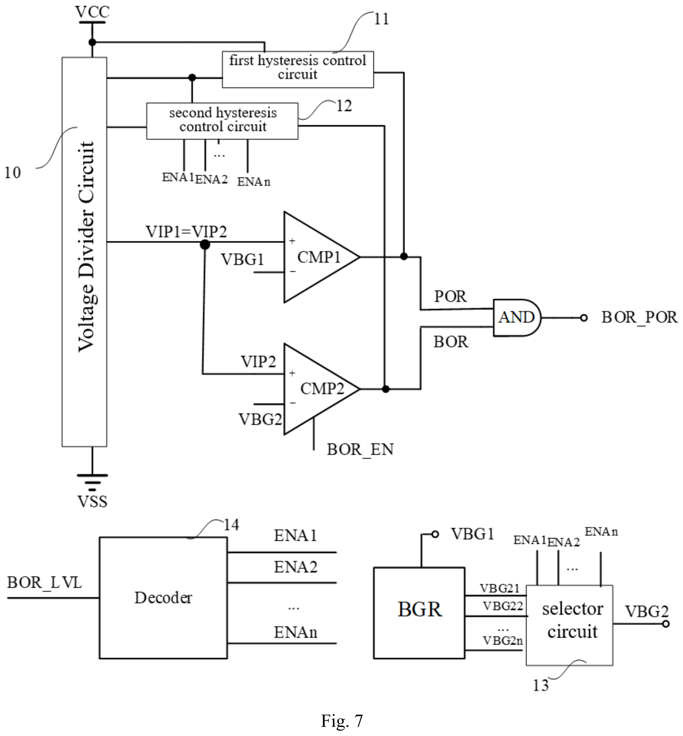

Referring to Fig. 7, a reset circuit according to a seventh embodiment of the present invention also includes a voltage divider circuit 10, a first comparator CMP1, a second comparator CMP2 and a first logic operation circuit 15. This embodiment differs from the sixth embodiment (1) in that reference voltages VBG21 to VBG2n defining n different ranges are provided by any suitable circuit such as a bandgap reference BGR and (2) in that the reset circuit further includes a decoder 14 and a selector circuit 13 for selecting one of the ranges to be monitored. The decoder 14 is configured to decode user-configured brown-out-level control signals BOR _LVL for the respective n ranges into n respective first enable signals ENA1 to ENAn. The selector circuit 13 is configured to select a reference voltage VBG2i for a desired one of the ranges from VBG21 to VBG2n for the respective n ranges under the control of the n first enable signals ENA1 to ENAn and output it as a desired second reference voltage VBG2 to the second comparator CMP2.

Each of the selector circuit 13 and the decoder 14 may be of any suitable circuit design. For example, the selector circuit 13 may include n selector switches SW1 to SWn, output terminals of which are connected together and to a second input terminal of CMP2. A control terminal of the selector switch SW1 is coupled to the first enable signal ENA1, and an input terminal of SW1 is coupled to the second reference voltage VBG21; a control terminal of the selector switch SW2 is coupled to the first enable signal ENA2, and an input terminal of SW2 is coupled to the second reference voltage VBG22; ...; and a control terminal of the selector switch SWn is coupled to the first enable signal ENAn, and an input terminal of SWn is coupled to the second reference voltage VBG2n.

The reset circuit of this embodiment provides a POR function in the same manner as in the first embodiment. Repeated description thereof is deemed unnecessary and omitted herein.

With combined reference to Figs. 7 and 5C, assume that a user has set low-power thresholds V_{BOR1} to V_{BORn} for the n ranges and that it is desired to perform BOR monitoring based on V_{BORi} in accordance with the actual circumstances. The reset circuit of this embodiment may provide a BOR function in a manner as described below.

First of all, the decoder 14 decodes the user-configured brown-out-level control signal BOR _LVL for the respective ranges into the respective first enable signals ENA1 to ENAn, which turn on only SWi in the selector circuit 13 and maintain all remaining SW in an OFF state. Accordingly, a second reference voltage VBG2i is provided to CMP2 as a desired second reference voltage VIP2.

During a rise of VCC, before it reaches V_{BORi}, i.e., when VCC<V_{BORi}, VIP2<VBG2i and CMP2 outputs BOR=0, maintaining some circuit modules in the system in a BOR state (or a deactivated or OFF state). When VCC≥V_{BORi}, VIP2≥VBG2i and CMP2 outputs BOR=1, driving those circuit modules in the system out of the BOR state into operation.

During a drop of VCC, when VCC≥V_{BORi}, VIP2≥VBG2i and CMP2 outputs BOR=1, maintaining those circuit modules in the system in operation. When VCC<V_{BORi}, VIP2<VBG2i and CMP2 outputs BOR=0, bringing those circuit modules in the system into the BOR state, where they are turned off to enable the system to consume less power.

As can be seen from the above, the reset circuit of this embodiment can also provide POR and BOR functions based on shared use of the single voltage divider circuit. Moreover, it enables low power monitoring of the power supply voltage in multiple ranges. This finer multi-range control of the system's functions can satisfy the requirements of various different use scenarios.

### EXAMPLE 8

Referring to Figs. 1A to 7, a chip according to an eighth embodiment includes the reset circuit of any of the foregoing embodiments. In one implementation, the chip may be a system-on-chip (SOC) including various modules in different power domains, which may be under different modes of BOR control.

The chip of this embodiment may be used in any suitable electronic device or system. Since the chip of this embodiment incorporates the inventive reset circuit, its area and cost can be reduced.

The description presented above is merely that of a few preferred embodiments of the present invention and does not limit the scope thereof in any sense. Any and all changes and modifications made by those of ordinary skill in the art based on the above teachings fall within the scope as defined in the appended claims.

## Claims

1. A reset circuit, comprising:
a voltage divider circuit (10) configured to detect a power supply voltage of a system and output a first tap voltage and a second tap voltage in response to the power supply voltage;
a first comparator coupled to the voltage divider circuit (10), the first comparator configured to compare the first tap voltage with a first reference voltage and thereby output a power-on reset signal during a power-on process of the system; and
a second comparator coupled to the voltage divider circuit (10), the second comparator configured to compare the second tap voltage with a second reference voltage and thereby output a brown-out reset signal during operation of the system,
wherein each of the power-on reset signal and the brown-out reset signal is used to cause a reset of the system.

2. The reset circuit of claim 1, further comprising a first logic operation circuit (15), which is coupled to an output terminal of the first comparator and an output terminal of the second comparator and is configured to perform a logical operation on the power-on reset signal and the brown-out reset signal and thereby output a system reset signal for causing the reset of the system.

3. The reset circuit of claim 1, wherein the voltage divider circuit (10) comprises a resistor string coupled between the power supply voltage and a ground of the system, wherein resistors in the resistor string are connected in series, and each of the first tap voltage and the second tap voltage is provided at an associated node in the resistor string.

4. The reset circuit of claim 1, wherein the first tap voltage is different from the second tap voltage, and the first reference voltage is equal to the second reference voltage, or wherein the first tap voltage and the second tap voltage are the same tap voltage, and the first reference voltage is lower than the second reference voltage.

5. The reset circuit of claim 4, further comprising:
a decoder (14) configured to decode brown-out-level control signals into n first enable signals; and
a selector circuit (13) for selecting a range to be monitored, the selector circuit (13) coupled to the decoder (14) and the second comparator, the selector circuit (13) configured to: when there is one second reference voltage for a single range and when the voltage divider circuit (10) is able to provide second tap voltages for respective n different ranges, select a second tap voltage for a respective range from the second tap voltages for the respective n different ranges under the control of the n first enable signals and output the second tap voltage to the second comparator; or when there are second reference voltages for respective n different ranges and when the voltage divider circuit (10) is able to provide one second tap voltage for a single range, select a second reference voltage for a respective range from the second reference voltages for the respective n different ranges under the control of the n first enable signals and output the second reference voltage to the second comparator.

6. The reset circuit of claim 5, wherein the selector circuit (13) comprises n selector switches for the n respective first enable signals, each of the selector switches comprises: a control terminal coupled to a respective one of the first enable signals; and an input terminal coupled to the second tap voltage or the first/second reference voltage for a respective one of the ranges.

7. The reset circuit of any one of claims 1 to 6, further comprising a first hysteresis control circuit (11), wherein the first hysteresis control circuit (11) comprises: a control terminal coupled to the output terminal of the first comparator; an input terminal coupled to the power supply voltage; and an output terminal coupled to the voltage divider circuit (10), the first hysteresis control circuit (11) configured to be turned on after the system is successfully powered on and when the power supply voltage is higher than an associated first power loss threshold, thereby preventing an undesired inversion of the power-on reset signal, the first power loss threshold being lower than a power-on threshold for the system.

8. The reset circuit of claim 7, wherein the first hysteresis control circuit (11) comprises a first switching transistor comprising: a gate serving as the control terminal of the first hysteresis control circuit (11) and coupled directly, or via a first inverting circuit, to the output terminal of the first comparator; and one of a source and a drain of the first switching transistor is coupled to the power supply voltage, and the other one of the source and the drain of the first switching transistor is coupled to the voltage divider circuit (10), when the first switching transistor is turned on, shorting a portion of the voltage divider circuit (10), thereby pulling up the first tap voltage.

9. The reset circuit of any one of claims 1 to 6 and 8, further comprising a second hysteresis control circuit (12), wherein the second hysteresis control circuit (12) comprises: a control terminal coupled to the output terminal of the second comparator; an input terminal coupled to the power supply voltage; and an output terminal coupled to the voltage divider circuit (10), the second hysteresis control circuit (12) configured to be turned on during operation of the system and when the power supply voltage is higher than a second power loss threshold, thereby preventing an undesired inversion of the brown-out reset signal, the second power loss threshold being higher than a power-on threshold for the system and lower than a low-power threshold for the system.

10. The reset circuit of claim 9, wherein the second hysteresis control circuit (12) comprises a second switching transistor comprising: a gate serving as the control terminal of the second hysteresis control circuit (12) and coupled directly, or via a second inverting circuit, to the output terminal of the second comparator; one of a source and a drain of the second switching transistor is coupled to the power supply voltage, the other one of the source and the drain of the second switching transistor is coupled to the voltage divider circuit (10), when the second switching transistor is turned on, shorting a portion of the voltage divider circuit (10), thereby pulling up the second tap voltage.

11. The reset circuit of claim 9, further comprising a decoder (14) configured to decode brown-out-level control signals into n first enable signals,
wherein the second hysteresis control circuit (12) comprises n second switching transistors and n second logic operation circuits (121 to 12n) for second power loss thresholds for the respective n different ranges, where n is an integer greater than 1,
each of the second switching transistors comprising: a gate coupled to an output terminal of a respective one of the second logic operation circuits (121 to 12n); and a source and a drain, one of which is coupled to the power supply voltage and the other of which is coupled to the voltage divider circuit (10), each of the second switching transistors, when turned on, shorting a respective portion of the voltage divider circuit (10), thereby pulling up the second tap voltage,
each of the second logic operation circuits (121 to 12n) comprising: a first input terminal coupled to a respective one of the first enable signals; and a second input terminal coupled to the output terminal of the second comparator, each of the second logic operation circuits (121 to 12n) configured to perform a logical AND or NAND operation on the respective first enable signal and the brown-out reset signal.

12. The reset circuit of claim 6 or 11, wherein the different ranges are associated with respective circuit modules in the system, and wherein when successfully powered on, the system turns off a respective one of the associated circuit modules based on the brown-out reset signal output for one of the ranges.

13. The reset circuit of any one of claims 1 to 6, 8 and 10 to 11, wherein the first comparator is activated by the power supply voltage whenever the power supply voltage is able to provide power, and wherein the second comparator is coupled to a second enable signal and configured to be activated when enabled by the second enable signal.

14. The reset circuit of claim 13, wherein the second enable signal and/or the brown-out-level control signals is/are user-configured, stored in a special non-volatile memory region of the system, and wherein the second enable signal and/or the brown-out-level control signals is/are read from the special memory region upon a power-on reset of the system.

15. A chip, comprising the reset circuit of any one of claims 1 to 14.
